**Europäisches Patentamt**

**European Patent Office**

**Office européen des brevets**

(19)

(11) Veröffentlichungsnummer : **0 075 331**
**B1**

(12) **EUROPÄISCHE PATENTSCHRIFT**

(45) Veröffentlichungstag der Patentschrift :
30.11.88

(51) Int. Cl.⁴ : **H 01 L 23/56, H 01 L 23/54**

(21) Anmeldenummer : **82108787.1**

(22) Anmeldetag : **22.09.82**

(54) Anordnung zur Kompensation von Korrosionseffekten in integrierten Halbleiterschaltkreisen.

(30) Priorität : **23.09.81 DE 3137914**

(43) Veröffentlichungstag der Anmeldung :
**30.03.83 Patentblatt 83/13**

(45) Bekanntmachung des Hinweises auf die Patenterteilung : **30.11.88 Patentblatt 88/48**

(84) Benannte Vertragsstaaten :
**AT DE FR GB IT**

(56) Entgegenhaltungen :
**DE-A- 3 002 740**
**FR-A- 2 202 367**
**GB-A- 1 251 456**
**US-A- 4 122 483**
**PATENTS ABSTRACTS OF JAPAN, Band 5, Nr. 149 (E-75)[821], 19. September 1981; & JP - A - 56 83 961 (TOKYO SHIBAURA DENKI K.K.) 08-07-1981**

(73) Patentinhaber : **Siemens Aktiengesellschaft Berlin und München**
**Wittelsbacherplatz 2**
**D-8000 München 2 (DE)**

(72) Erfinder : **Goetz, Rolf Jürgen, Dr. Dipl.-Phys.**
**Finkenweg 3**
**D-8059 Oberneuching (DE)**

## Beschreibung

Die vorliegende Erfindung betrifft eine Anordnung zur Kompensation von durch schnell bewegliche positive Ionen in Isolationsoxiden von integrierten Halbleiterschaltkreisen bedingten Korrosionseffekten.

Es ist bekannt, daß in Isolationsoxiden von Halbleiterbauelementen, insbesondere von integrierten Schaltkreisen schnell bewegliche positive Ionen gelöst sind. Diese Ionen können zur Korrosion vom auf dem Schaltkreis vorgesehenen Aluminium-Leiterbahnen oder auch zu Änderungen der Einsatzspannung von im integrierten Halbleiterschaltkreis befindlichen Funktionseinheiten führen.

In DE-A-3002740 ist ein integrieter Halbleiterschaltkreis offenbart, bei dem ein auf Substrat potential gehaltener Ring aus Polysilicium das Eindringen von Natriumionen in die Feldoxidschicht verhindert.

Der vorliegenden Erfindung liegt die Aufgabe zugrunde, eine Möglichkeit zur Vermeidung der durch die genannten positiven Ionen bedingten Korrosionseffekten anzugeben.

Diese Aufgabe wird bei einer Anordnung der eingangs genannten Art erfindungsgemäß durch einen auf der Oberfläche des Halbleiterschaltkreises vorgesehenen, an eine negative Spannung angeschlossenen Ring aus einem gegen Korrosion aufgrund von positiven Ionen im Betrieb von Halbleiterschaltkreisen beständigen Material gelöst.

Ausgestaltungen des vorstehend definierten Erfindungsgedankens sind in Unteransprüchen gekennzeichnet.

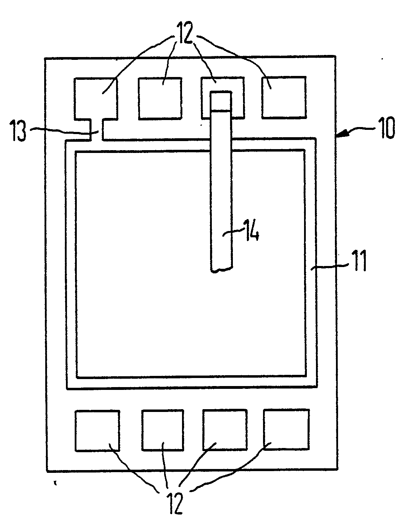

Die Erfindung wird im folgenden anhand eines in der einzigen Figur der Zeichnung dargestellten Ausführungsbeispiels näher erläutert. Die Figur zeigt eine schematische Darstellung eines integrierten Halbleiterschaltkreises mit einem erfindungsgemäßen Ring.

Auf der Oberfläche eines schematisch dargestellten Halbleiterschaltkreises 10, die durch eine Oxid-Ebene gebildet ist, ist erfindungsgemäß ein Ring 11 aus einem Material aufgebracht, das im Betrieb von Halbleiterschaltkreisen gegen Korrosion aufgrund von positiven Ionen beständig ist. Als Material kommen etwa Polysilicium oder Silizide, wie Tantalsilizid, Molybdänsilizid oder Wolframsilizid in Frage. Außerhalb dieses Ringes können Anschlußelektroden (pads) 12 liegen, über welche die im integrierten Halbleiterschaltkreis 10 realisierte elektrische Schaltung nach außen zugänglich ist.

Um den Ring 11 an eine negative Spannung anschließen zu können, kann man beispielsweise eine leitende Verbindung 13 in Form einer Aluminium-Leiterbahn oder einer Polysilicium-Leiterbahn zu einer Anschlußelektrode 12 führen, an der dann die negative Spannung für den Ring 11 anliegt.

Der an der negativen Spannung liegende Ring 11 wirkt somit als Falle für die im Oxid auf der Oberfläche des Halbleiterschaltkreises gelösten schnellbeweglichen positiven Ionen.

Die Maßnahme eines an negative Spannung liegenden Rings als Korrosionsschutz ist deshalb möglich, weil in Isolationsoxiden von Halbleiterbauelementen und integrierten Schaltkreisen praktisch nur positive Ionen, aber keine negativen Ionen gelöst sind.

Da auf der Oberfläche von integrierten Halbleiterschaltkreisen auch Leiterbahnen, insbesondere in Form von Aluminium-Leiterbahnen verlaufen, die gegen Korrosion durch die positiven Ionen geschützt werden sollen, kann der Ring 11 beispielsweise zur Führung von Leiterbahnen an die Anschlußelektroden 12 auch unterbrochen sein. Eine derartige Maßnahme ist in der Figur schematisch durch eine zu einer Anschlußelektrode 12 führende Leiterbahn 14 dargestellt.

## Patentansprüche

1. Anordnung zur Vermeidung von durch schnell bewegliche positive Ionen in Isolationsoxiden von integrierten Halbleiterschaltkreisen bedingten Korrosionseffekten, gekennzeichnet durch einen auf der Oberfläche des Isolationsoxids des Halbleiterschaltkreises (10) vorgesehenen, an eine negative Spannung angeschlossenen Ring (11) aus einem gegen Korrosion aufgrund von positiven Ionen im Betrieb von Halbleiterschaltkreisen beständigen Material.

2. Anordnung nach Anspruch 1, dadurch gekennzeichnet, daß als Material für den Ring (11) Polysilicium Verwendung findet.

3. Anordnung nach Anspruch 1, dadurch gekennzeichnet, daß als Material für den Ring (11) ein Silizid, beispielsweises Tantalsilizid, Molybdänsilizid oder Wolframsilizid Verwendung findet.

4. Anordnung nach einem der Ansprüche 1 bis 3, dadurch gekennzeichnet, daß der Ring (11) innerhalb von Anschlußelektroden (12) des Halbleiterschaltkreises (10) vorgesehen ist.

5. Anordnung nach einem der Ansprüche 1 bis 4, dadurch gekennzeichnet, daß der Ring (11) an Stellen an denen Leiterbahnen (14) zu den Anschlußkontaktelektroden (12) geführt sind, unterbrochen ist.

6. Anordnung nach einem der Ansprüche 1 bis 5, gekennzeichnet durch mindestens eine leitende Verbindung (13) vom Ring (11) aus Polysilicium zumindestens einer Anschlußelektrode (12).

## Claims

1. An arrangement for avoiding corrosion effects caused by rapidly moving positive ions in insulating oxide layers of integrated semiconductor circuits, characterised by a ring (11) which is arranged on the surface of the insulating oxide layer of the semiconductor circuit (10), is connected to a negative voltage, and is made of a material which is resistant to corrosion caused by positive ions during the operation of semiconductor circuits.

2. An arrangement as claimed in Claim 1, characterised in that polysilicon is used as the material for the ring (11).

3. An arrangement as claimed in Claim 1, characterised in that a silicide, for example tantalum silicide, molybdenum silicide, or tungsten silicide, is used as the material for the ring (11).

4. An arrangement as claimed in one of Claims 1 to 3, characterised in that the ring (11) is arranged within terminal electrodes (12) of the semiconductor circuit (10).

5. An arrangement as claimed in one of Claims 1 to 4, characterised in that the ring (11) is interrupted at locations at which terminal conductor paths (14) lead to the terminal contact electrodes (12).

6. An arrangement as claimed in one of Claims 1 to 5, characterized by at least one conductive connection (13) from the polysilicon ring (11) of at least one terminal electrode (12).

**Revendications**

1. Dispositif pour éviter des effets de corrosion dus à des ions positifs à déplacement rapide dans des oxydes isolants de circuits intégrés à semiconducteurs, caractérisé par un anneau (11) prévu sur la surface de l'oxyde isolant du circuit à semiconducteurs (10) et placé à une tension négative et constitué en un matériau résistant à la corrosion due à des ions positifs pendant le fonctionnement de circuits à semiconducteurs.

2. Dispositif suivant la revendication 1, caractérisé par le fait qu'on utilise, comme matériau pour l'anneau (11), du polysilicium.

3. Dispositif suivant la revendication 1, caractérisé par le fait qu'on utilise, comme matériau pour l'anneau (11), un siliciure, par exemple un siliciure de tantale, un siliciure de molybdène ou un siliciure de tungstène.

4. Dispositif suivant l'une des revendications 1 à 3, caractérisé par le fait que l'anneau (11) est prévu à l'intérieur d'électrodes de raccordement (12) du circuit à semiconducteurs (10).

5. Dispositif suivant l'une des revendications 1 à 4, caractérisé par le fait que l'anneau (11) est interrompu en des emplacements, au niveau desquels des voies conductrices (14) sont raccordées aux électrodes de raccordement (12).

6. Dispositif suivant l'une des revendications 1 à 5, caractérisé par au moins une liaison conductrice (13) entre l'anneau (11) réalisé en polysilicium et au moins une électrode de raccordement (12).